Europäisches Patentamt

European Patent Office

Office européen des brevets

(19)

(11) **EP 0 928 972 B1**

(12) **EUROPÄISCHE PATENTSCHRIFT**

(45) Veröffentlichungstag und Bekanntmachung des Hinweises auf die Patenterteilung:
**01.06.2005 Patentblatt 2005/22**

(51) Int Cl.7: **G01R 33/28**, G01R 33/563, A61B 5/055

(21) Anmeldenummer: **99200025.7**

(22) Anmeldetag: **06.01.1999**

(54) **MR-Verfahren mit einer im Untersuchungsbereich befindlichen Mikrospule**

Magnetic resonance method comprising a micro-coil in the volume of investigation

Méthode de résonance magnétique utilisant une micro-bobine dans le volume d'examen

(84) Benannte Vertragsstaaten:
**DE FR GB NL**

(30) Priorität: **09.01.1998 DE 19800471**

(43) Veröffentlichungstag der Anmeldung:
**14.07.1999 Patentblatt 1999/28**

(73) Patentinhaber:
• **Philips Corporate Intellectual Property GmbH 52064 Aachen (DE)**
• **Koninklijke Philips Electronics N.V. 5621 BA Eindhoven (NL)**
Benannte Vertragsstaaten:
**FR GB NL**

(72) Erfinder:
• **Lüdeke, Kai-Michael**
**Röntgenstrasse 24, 22335 Hamburg (DE)**
• **Rasche, Volker, Dr.**
**Röntgenstrasse 24, 22335 Hamburg (DE)**

(74) Vertreter: **Volmer, Georg, Dipl.-Ing. et al**
**Philips Intellectual Property & Standards GmbH, Postfach 50 04 42**
**52088 Aachen (DE)**

(56) Entgegenhaltungen:
EP-A- 0 768 539          WO-A-99/19739
US-A- 5 221 898          US-A- 5 445 151

• BURL M ET AL: "TUNED FIDUCIAL MARKERS TO IDENTIFY BODY LOCATIONS WITH MINIMAL PERTURBATION OF TISSUE MAGNETIZATION" MAGNETIC RESONANCE IN MEDICINE, US, ACADEMIC PRESS, DULUTH, MN, Bd. 36, Nr. 3, 1. September 1996 (1996-09-01), Seiten 491-493, XP000624684 ISSN: 0740-3194
• HURST G C ET AL: "INTRAVASCULAR (CATHETER) NMR RECEIVER PROBE: PRELIMINARY DESIGN ANALYSIS AND APPLICATION TO CANINE ILIOFEMORAL IMAGING" MAGNETIC RESONANCE IN MEDICINE, US, ACADEMIC PRESS, DULUTH, MN, Bd. 24, Nr. 2, 1. April 1992 (1992-04-01), Seiten 343-357, XP000275075 ISSN: 0740-3194

EP 0 928 972 B1

**Beschreibung**

Die Erfindung betrifft ein MR-Verfahren, bei dem die Kernmagnetisierung in einem in einem Untersuchungsbereich befindlichen Untersuchungsobjekt durch wenigstens einen magnetischen Hochfrequenzimpuls angeregt wird, bei dem die anschließend von einer MR-Spule empfangenen MR-Signale für wenigstens ein MR-Bild herangezogen werden und bei dem in das Untersuchungsobjekt mindestens ein auf die MR-Frequenz abgestimmter und von Anschlussleitungen freier Resonanzkreis mit einer Mikrospule eingeführt ist. Dabei werden die MR-Signale so verarbeitet, dass die durch die Mikrospule lokal bewirkte Änderung des durch die Hochfrequenzimpulse im Untersuchungsobjekt entstehenden Magnetfeldes in dem MR-Bild sichtbar wird. Außerdem betrifft die Erfindung eine MR-Anordnung zur Durchführung dieses Verfahrens.

Dabei wird die Tatsache ausgenutzt, dass das mit den Hochfrequenzimpulsen einhergehende Magnetfeld im Nahbereich (das ist das der von der Mikrospule umschlossenen Bereich und der Bereich außerhalb der Mikrospule, in dem sich im wesentlichen das Magnetfeld der Spule konzentriert) der Mikrospule erhöht wird. Die Kernmagnetisierung wird daher im Bereich der Mikrospule in anderem Maße beeinflusst als im übrigen Untersuchungsbereich, und dies kann in einem MR-Bild sichtbar gemacht werden.

Ein solches Verfahren und eine solche Anordnung sind aus der EP-A-768 539 bekannt. Die Mikrospule ist an einem medizinischen Instrument befestigt, beispielweise einem Katheter. Die Mikrospule kann zwei (oder mehr) Teilspulen aufweisen, die zueinander senkrecht stehen. Dadurch wird erreicht, dass unabhängig von der Lage der Mikrospule stets mindestens eine Teilspule wirksam ist, wodurch die Mikrospule stets eine lokale Erhöhung des Magnetfeldes erzeugt. Insbesondere wenn die Mikrospule sehr klein ist, fällt diese punktförmige Erhöhung in einem MR-Bild möglicherweise kaum auf.

Es ist Aufgabe der vorliegenden Erfindung, ein Verfahren der eingangs genannten Art so auszugestalten, daß die Mikrospule noch besser lokalisiert werden kann. Diese Aufgabe wird durch die im Anspruch 1 angegebenen Maßnahmen gelöst

In den Spulenabschnitten mit unterschiedlichem Wicklungssinn ergeben sich voneinander abweichende Phasenlagen und gegebenenfalls Amplituden des Magnetfeldes, die in einem MR-Phasenbild leicht als charakteristisches Phasenmuster wahrgenommen werden können. Bei einer sehr geringen Spulengüte, bei der die Erhöhung des Magnetfeldes kaum im MR-Bild nachweisbar ist, können sich immer noch erhebliche Phasenänderungen ergeben, die in dem Phasenbild sichtbar werden.

Anspruch 3 beschreibt eine bevorzugte Anwendung der dabei benutzten Mikrospule.

Anspruch 4 beschreibt eine Anwendung von Mikrospulen zur Flußvisualisierung, beispielsweise zur Darstellung des in den Blutgefäßen fließenden Blutstromes. Wenn beispielsweise eine Mikrospule in ein Blutgefäß eingeführt wird, wird die Kernmagnetisierung in dem Blutvolumen angeregt, das sich im Zeitpunkt des anregenden Hochfrequenzimpulses im Innern der Mikrospule befindet. Dieses Blutvolumen verschiebt sich jedoch mit dem Blutstrom, und deshalb hängt seine Lage im MR-Bild von dem zeitlichen Abstand zwischen dem Hochfrequenzimpuls und dem Empfang des bzw. der MR-Signale ab, aus denen das MR-Bild abgeleitet wird. Die im Anspruch 4 beschriebene Ausgestaltung erlaubt daher eine Untersuchung der Ausbreitung des Blutvolumens.

Es sei an dieser Stelle erwähnt, dass aus der US-A-5445151 bereits eine Flußvisualisierung mit Hilfe von Mikrospulen bekannt ist, wobei mittels einer Mikrospule eine Sättigung der Magnetisierung erfolgt, die von mindestens einer Mikrospule flußabwärts detektiert wird. Im Gegensatz zur Erfindung sind diese Mikrospulen jedoch mit Zuleitungen versehen. Dadurch besteht die Gefahr, dass in den Anschlussleitungen, die die im Untersuchungsobjekt befindliche Mikrospule mit dem MR-Empfänger verbinden, durch Hochfrequenzimpulse Spannungen induziert werden, die zu Verbrennungen des Untersuchungsobjekts in der Umgebung der Anschlussleitungen führen können

Die Weiterbildung nach Anspruch 5, wobei die Projektionsrichtung vorzugsweise senkrecht zur Flußrichtung verläuft, ermöglicht dabei ein sehr schnelles Untersuchungsverfahren.

Anspruch 6 beschreibt eine MR-Anordnung zur Durchführung des MR-Verfahrens.

Die Erfindung wird nachstehend anhand der Zeichnungen näher erläutert. Es zeigen:

Fig. 1 eine stark vereinfachte Darstellung eines MR-Gerätes, in dem eine Mikrospule eingesetzt wird,

Fig. 2 das Prinzipschaltbild eines solchen Gerätes,

Fig. 3 das Ersatzschaltbild einer Mikrospule,

Fig. 4 das Ersatzschaltbild einer modifizierten Mikrospule und

Fig. 5 den zeitlichen Verlauf verschiedener Signale bei einer Sequenz zur Flußvisualisierung.

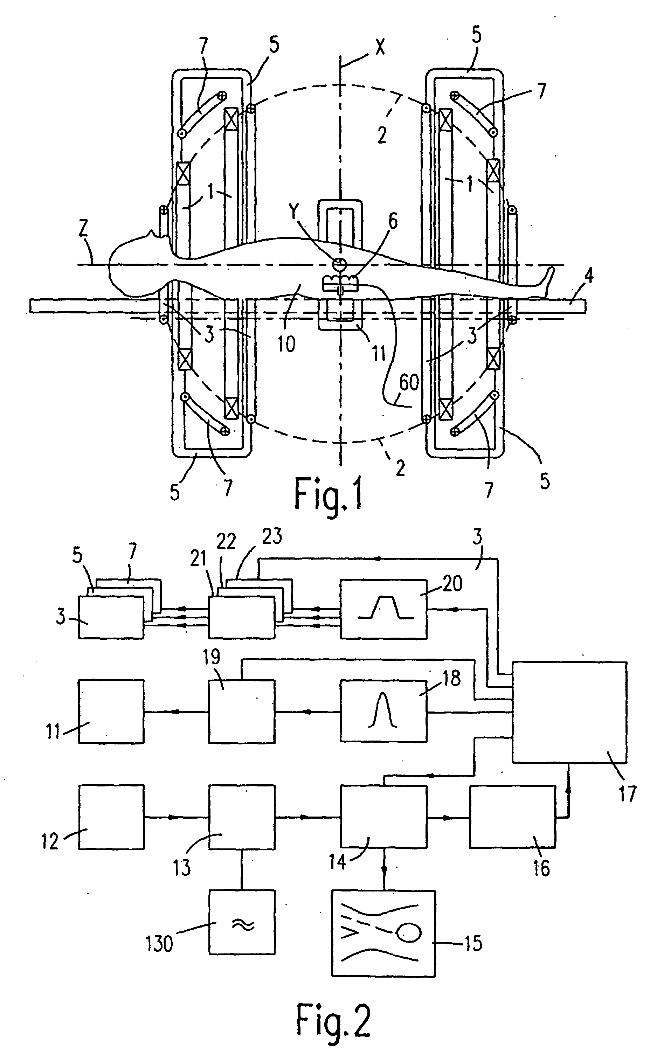

Das in Fig. 1 schematisch dargestellte Kernspinuntersuchungsgerät enthält eine aus vier Spulen 1 bestehende Anordnung zur Erzeugung eines homogenen stationären Magnetfeldes, das in der Größenordnung von einigen Zehntel T bis einigen T liegen kann. Die zur z-Achse konzentrisch angeordneten Spulen 1 können auf einer Kugeloberfläche 2 angeordnet sein. Im Innern dieser Spulen befindet sich ein Untersuchungsobjekt, zB. ein Patient 10 auf einer Tischplatte 4. In den Patienten ist ein Katheter 60 eingeführt, an dessen Spitze sich eine Mikrospule 6 befindet.

Zur Erzeugung eines in z-Richtung verlaufenden und sich in dieser Richtung linear ändernden Magnetfeldes sind vier Spulen 3 auf der Kugeloberfläche 2 oder einer Zylinderoberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) erzeugen, dessen Gradient jedoch in x-Richtung (vertikal) verläuft. Ein in z-Richtung verlaufendes magnetisches Gradientenfeld mit einem Gradienten in y-Richtung (senkrecht zur Zeichenebene der Fig. 1) wird von vier Spulen 5 erzeugt, die mit den Spulen 7 identisch sein können, die jedoch diesen gegenüber um 90° räumlich versetzt angeordnet sind. Von diesen vier Spulen sind in Fig. 1 nur zwei dargestellt. Die Feldstärke im Kugelzentrum ist nur durch das stationäre homogene Magnetfeld der Spule 1 bestimmt.

Der zeitliche Verlauf der von den Gradientenspulen 3, 5 und 7 erzeugten magnetischen Gradientenfelder wird gemäß Fig. 2 von einem Gradienten-Wellenform-Generator 20 bestimmt, der von einer Steuereinheit 17 gesteuert wird. Die von dem Generator 20 vorgegebene Wellenform wird mindestens einem der Gradientenverstärker 21, 22 und 23 zugeführt, die den Strom für die Gradientenspulen 3,5 und 7 liefern. Die Verstärkungsfaktoren der Gradientenverstärker 21, 22 und 23 sind durch die Steuereinheit 17 unabhängig voneinander einstellbar.

Weiterhin ist eine Hochfrequenz-Sendespule 11 vorgesehen, die impulsweise ein hochfrequentes, räumlich nahezu homogenes und senkrecht zur Richtung des stationären homogenen Magnetfeldes (d.h. senkrecht zur z-Richtung) verlaufendes Magnetfeld erzeugt. Die Mittenfrequenz und die Umhüllende der von Spule 11 erzeugten Hochfrequenzimpulse wird von einem Generator 18 (Fig.2) vorgegeben, der ebenfalls von der Steuereinheit 17 gesteuert wird. Die Steuereinheit 17 steuert auch die Verstärkung eines Verstärkers 19, über den das von dem Generator 18 gelieferte Hochfrequenzsignal der Hochfrequenz-Sendespule 11 zugeführt wird.

Die Hochfrequenz-Sendespule 11 könnte auch zum Empfangen der im Untersuchungbereich erzeugten Kernresonanzsignale dienen. Zweckmäßigerweise wird dafür jedoch eine gesonderte, in Fig 2 mit 12 bezeichnete Hochfrequenzempfangsspule verwendet. Die von dieser Hochfrequenzempfangsspule empfangenen MR-Signale werden in einem Quadratur-Demodulator 13 durch Mischung mit zwei um 90° gegeneinander versetzten Trägerschwingungen (mit der durch die Stärke des stationären Magnetfeldes bestimmten Larmor- bzw. MR-Frequenz) eines Oszillators 130 demoduliert, so daß zwei Signale erzeugt werden, die als Realteil und als Imaginärteil eines komplexen MR-Signals aufgefaßt werden können. Diese Signale werden einem Analog-Digitalwandler 14 zugeführt, der daraus MR-Daten bildet. Aus den MR-Daten werden in einer Bildverarbeitungseinheit 16 MR-Bilder rekonstruiert, die die Kernmagnetisierung im Untersuchungsbereich darstellen. Diese MR-Bilder werden auf einem Monitor 15 wiedergegeben.

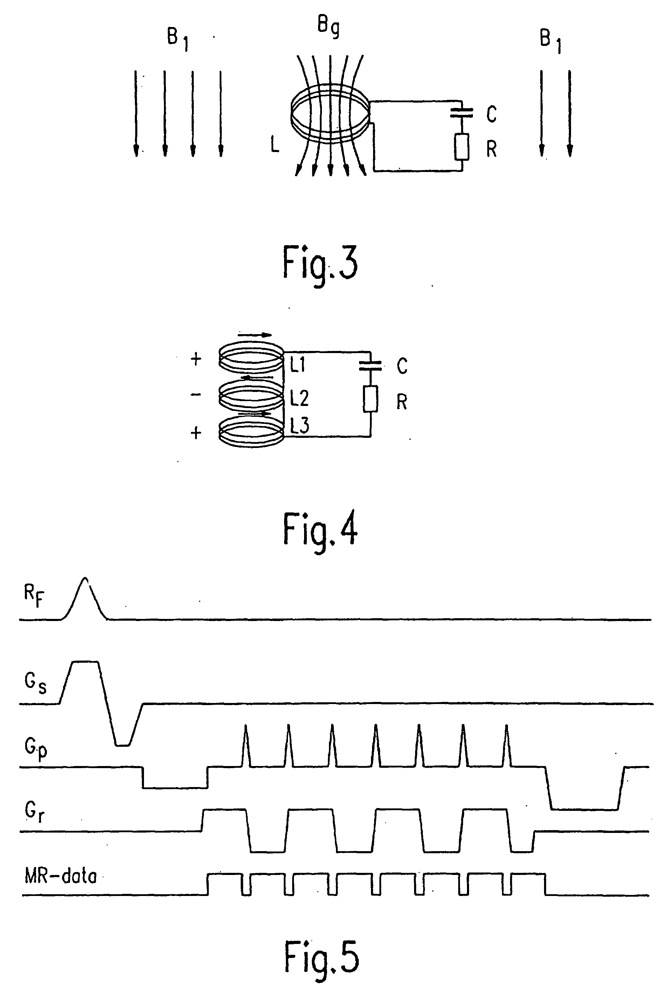

Fig. 3 zeigt das Ersatzschaltbild der Mikrospule 6 gemäß Fig. 1. Die Mikrospule 6 umfaßt eine Induktivität L, deren Form und Gestalt vom jeweiligen Verwendungszweck abhängt, die jedoch klein ist im Vergleich zur Hochfrequenz-Sendespule 11 und im allgemeinen klein im Vergleich zur Hochfrequenz-Empfangsspule 12. Die Induktivität L ist durch einen Kondensator C auf die MR-Frequenz, d.h. auf die Mittenfrequenz der von der Hochfrequenz-Sendespule 11 erzeugten Hochfrequenzimpulse abgestimmt. Der Widerstand R verkörpert dabei die in der Mikrospule auftretenden Verluste. Je geringer diese Verluste sind, desto höher ist die Güte Q der Spule.

Durch die Hochfrequenzspule 11 wird im Untersuchungsbereich ein (zumindest im Bereich der Mikrospule) räumlich homogenes Magnetfeld mit der magnetischen Flußdichte $B_1$ hervorgerufen. Dies bewirkt in dem durch die Elemente L, C und R Resonanzkreis einen Strom, der seinerseits ein die Spule zusätzlich durchsetzendes Magnetfeld erzeugt, das sich dem äußeren Magnetfeld der Hochfrequenzspule überlagert. Das gesamte die Spule durchsetzende Magnetfeld hat dann im Innern der Spule einen räumlichen Mittelwert der Flußdichte $B_g$, für den die Beziehung gilt:

$$B_g = B_1 \; \frac{Q + j}{j}; \qquad \text{mit } j = \sqrt{-1} \qquad (1)$$

Gleichung 1 besagt, daß die durch einen Hochfrequenzimpuls mit einer Flußdichte $B_1$ im Nahfeld der Mikrospule hevorgerufene magnetische Flußdichte (bzw. der magnetische Fluß durch die Mikrospule) umso größer ist, je größer die Güte Q ist. Für große Werte von Q ist $B_g$ näherungsweise um den Faktor Q größer als B,. Das bedeutet, daß man mit einem Hochfrequenzimpuls, der die Kernmagnetisierung in größerem Abstand von der Spule L kaum anregt, innerhalb der Spule die Kernmagnetisierung stark anregen und z.B. um 90° aus ihrer Ruhelage kippen kann. Die Abbildung des Nahbereichs der Mikrospule im MR-Bild unterscheidet sich also deutlich von der Abbildung der außerhalb befindlichen Bereiche.

Die Gleichung 1 zeigt weiter, daß zwischen der (räumlich gemittelten) Flußdichte $B_g$ der Mikrospule und der Flußdichte $B_1$, der durch die Hochfrequenz-Sendespule 11 hervorgerufen wird, eine Phasenverschiebung φ besteht, wobei näherungsweise die Beziehung gilt:

$$\varphi \approx - \arctan Q$$

Für höhere Werte Q der Spulengüte ist die Phasenverschiebung φ also nahezu 90°

Der Phasenverlauf φ der magnetischen Flußdichte $B_i$ nahe der Mikrospule läßt sich mit einem Phasenbild darstellen, das die räumliche Phasen der Kernmagnetisierung wiedergibt. Im Bereich der Mikrospule ergibt sich eine starke Phasenänderung. Um ein solches Phasenbild darzustellen, wird das vom Quadratur-Demodulator 13 (Fig. 2) gelieferte komplexe Signal in der Bildverarbeitungseinheit 16 einer Fourier-Transformation unterzogen, die komplexe Bildwerte (mit Realteil und Imaginärteil) liefert. Aus dem Verhältnis von Real- und Imaginärteil läßt sich für jeden Bildpunkt die Phase der angeregten Kernmagnetisierung bestimmen.

Die in Fig. 3 schematisch dargestellte Hochfrequenzspule bewirkt in ihrem Innern die aus Gleichung 1 ersichtliche Erhöhung der Magnetflußdichte. Dies ist zwar einerseits erwünscht, kann aber andererseits dann stören, wenn auf den Untersuchungsbereich Sequenzen für eine normale MR-Bildgebung einwirken. Darüber hinaus kann bei sehr kleinen Mikrospulen der Bereich mit erhöhter Magnetflußdichte so klein sein, daß er in einem stark verrauschten MR-Bild kaum auffällt.

Fig. 4 beschreibt daher eine (erfindungsgemäße) Ausführungsform einer Mikrospule, die für verschiedene Anwendungen günstiger ist als die Mikrospule nach Fig. 3. Dabei ist eine aus drei Teilen $L_1$, $L_2$ und $L_3$ bestehende Induktivität vorgesehen, deren mittlerer Teil $L_2$ einen umgekehrten Wickelsinn hat wie die beiden äußeren Teile $L_1$ und $L_3$. Durch diese Anordnung erhält man zwar bei gleich großen Teilspulen nur etwa ein Drittel der bei einer gleichsinnig gewickelten Spule erzielbaren $B_1$-Erhöhung, dafür aber ein komplexes - und in einem MR-Bild relativ leicht zu erkennendes - Muster mit einer Phase von nahezu -90° in den äußeren Teilen und knapp +90° im mittleren Teil. Man kann die Unterteilung in Spulenabschnitte auch so weit treiben, daß nur noch eine geringe $B_1$-Erhöhung auftritt, dafür aber eine gut erkennbare Phasenmarkierung mit hohen Ortsfrequenzen stattfindet.

Im folgenden soll anhand von Fig. 5 erläutert werden, wie man mit derartigen Mikrospulen das Strömen einer flüssigen Substanz im Untersuchungsbereich - z.B. Blut oder ein Kontrastmittel - sichtbar machen kann. Fig. 5 zeigt in der ersten Zeile einen Hochfrequenzimpuls $R_f$ und in der zweiten, dritten und vierten Zeile den zeitlichen Verlauf der magnetischen Gradientenfelder $G_s$ für die Schichtselektion, $G_p$ für die Phasenkodierung und $G_r$ für das Auslesen der MR-Signale. In der fünften Zeile ist dargestellt, wann bei dieser Sequenz von EPI-Typ MR-Signale akquiriert werden.

Zunächst wird mit Hilfe des Hochfrequenzimpulses und des Schichtselektionsgradienten $G_s$ eine Schicht angeregt, die die Mikrospule 6 enthält. Dadurch wird die Kernmagnetisierung in dem Blut- bzw. Kontrastmittelvolumen angeregt, das sich im Zeitpunkt der Anregung im Nahbereich der Mikrospule befindet. Diesem Blut- bzw. Kontrastmittelvolumen wird ein Kernmagnetisierungsmuster aufgeprägt, das sich deutlich von seiner Umgebung unterscheidet, und deshalb kann anhand der Ausbreitung dieses Musters das Fließen des zuvor angeregten Volumens verfolgt werden. Da lediglich ein sehr lokalisierter Bereich gemessen werden muß, ist es möglich, diesen Bereich mit vergleichsweise wenigen Stützstellen im sogenannten k-Raum zu messen, was die Verwendung sehr schneller MR-Sequenzen erlaubt, wie dem in der Zeichnung dargestellten EPI-Verfahren mit einem einzelnen Anregungsimpuls.

Dabei wird nach dem schichtselektiven Hochfrequenzimpuls der Phasenkodierungsgradient derart ein- und ausgeschaltet, daß im k-Raum die maximale Phasenkodierung erreicht wird. Danach wird ein Lesegradient $G_r$ mit ständig wechselnder Polarität eingeschaltet, wobei bei jedem Polaritätswechsel ein kurzer "Blip" des Phasenkodierungsgradienten $G_p$ wirksam wird, wodurch im Anschluß daran jeweils eine benachbarte Linie im k-Raum abgetastet wird, wobei jeweils ein MR-Signal erfaßt wird. Nach dem letzten Polaritätswechsel wird der Phasenkodierungsgradient mit der entgegengesetzten Polarität wie die "Blips" eingeschaltet und mit einem solchen zeitlichen Integral, daß derselbe Punkt im k-Raum erreicht wird wie vor Beginn der Sequenz.

Anschließend werden die Phasenkodierungs- und Auslesevorgänge in bestimmten zeitlichen Abständen - aber ohne einen erneuten Hochfrequenzimpuls - wiederholt, so daß die weitere Ausbreitung des durch den Hochfrequenzimpuls angeregten Volumens verfolgt werden kann. Die sich dabei ergebenden Abbildungen können in eine zuvor angefertigte Übersichtsaufnahme oder ein Angiogramm eingeblendet werden.

Der zeitliche Abstand der letzten Wiederholung des Auslesezyklus vom Hochfrequenzimpuls ist durch die Dephasierung infolge der Magnetfeld-Inhomogenität und dergl. begrenzt. Um diese Dephasierung zu verringern, wäre es möglich, nach jedem Auslesezyklus einen 180°-Hochfrequenzimpuls zu erzeugen, der die Kernmagnetisierung in dem zuvor angeregten Volumenteil refokussiert.

Andererseits kann es möglich sein, daß das MR-Signal der angeregten Spins sehr schnell dephasiert und eine Studie anhand kompletter MR-Bilder (wenn auch nur mit wenigen Linien im k-Raum) aufgrund der endlichen Meßzeit nicht möglich ist. In diesem Fall könnte die Sequenz auf die Messung von Projektionen - vorzugsweise in der Flußrichtung, in der sich das Blut- oder Kontrastmittelvolumenteil ausbreitet - reduziert werden. Durch Wiederholung dieser Messung in bestimmten zeitlichen Abständen ohne erneute Anregung könnte das dynamische Verhalten des angeregten Volumens untersucht werden. Dazu muß bei der Sequenz in Fig. 5 lediglich der Phasenkodierungsgradient ständig abgeschaltet sein.

Eine andere Möglichkeit, um die Ausbreitung einer kontinuierlich strömenden Flüssigkeit (z.B. Blut) zu verfolgen, besteht darin, mehrere MR-Bilder zu erzeugen, wobei vor jedem MR-Bild eine Anregung der Kernmagnetisierung durch je einen Hochfrequenzimpuls erfolgt und die zeitlichen Abstände zwischen dem Hochfrequenzimpuls und dem Auslesen der MR-Signale variiert werden. Um die Vergleichbarkeit sicherzustellen, sollte der Hochfrequenzimpuls jeweils in derselben Phase des Herzzyklus erzeugt werden.

Die Mikrospulen können auch dazu verwendet werden, um beispielsweise ein in den Untersuchungsbereich eingeführtes Instrument (z.B. einen Katheter) zu lokalisieren, an dessen Spitze eine oder mehrere Mikrospulen angebracht sind. Bei Verwendung von mehreren Mikrospulen ist deren Lokalisierung wesentlich einfacher als bei Verwendung von Mikrospulen, die über je eine Anschlußleitung mit dem MR-Empfänger verbunden sind.

Bei vielen Anwendungen ist es nicht notwendig, die gesamte Anatomie zu sehen. Vielmehr ist lediglich ein räumlich stark begrenzter Bereich von Interesse (z.B. Biopsien, ....). Da die Größe des abzubildenden Bereichs direkt die Meßzeit beeinflußt, ist es für fluoroskopische Anwendungen wichtig, den abzubildenden Bereich so klein wie möglich zu halten. Mittels der in den Mikrospulen erzeugten Erhöhung des Magnetfeldes kann eine räumlich beschränkte Anregung mit einer geeigneten Kombination von Spulengröße, Spulengüte und Flipwinkel erreicht werden. Durch die Wahl sehr kleiner Flipwinkel wird (bei hoher Spulengüte) wiederum erreicht, daß lediglich Spins innerhalb der Spule ein signifikantes MR-Signal erzeugen. Für die Darstellung verschiedener Bereiche innerhalb des Körpers (z.B. Magen, Darm usw.) können dedizierte Spulen eingesetzt werden.

Die durch die Mikrospulen bewirkte Erhöhung des äußeren Magnetfeldes kann auch zur Hyperthermie benutzt werden, wobei Hochfrequenzimpuls von entsprechender Stärke erzeugt werden, die infolge der Erhöhung der magnetischen Flußdichte in deren Nahbereich eine lokale Erwärmung hervorrufen. Dabei kann dieselbe Spule dazu benutzt werden, um auch die Lage der betreffenden Mikrospule in einem MR-Bild zu bestimmen und gegebenenfalls auch zur (MR-)Messung der Temperaturerhöhung.

**Patentansprüche**

1. MR-Verfahren, bei dem die Kernmagnetisierung in einem in einem Untersuchungsbereich befindlichen Untersuchungsobjekt durch wenigstens einen magnetischen Hochfrequenzimpuls angeregt wird, bei dem die anschließend von einer MR-Spule empfangenen MR-Signale für wenigstens ein MR-Phasenbild herangezogen werden und bei dem in das Untersuchungsobjekt mindestens ein auf die MR-Frequenz abgestimmter und von Anschlußleitungen freier Resonanzkreis mit einer Mikrospule eingeführt ist, die mehrere räumlich getrennte Abschnitte ($L_1$, $L_2$, $L_3$) mit unterschiedlichem Wicklungssinn aufweist, sodaß in dem MR-Phasenbild lokal ein Phasenmuster erzeugt wird, in dem durch aufeinanderfolgende Abschnitte mit unterschiedlichem Wicklungssinn stets eine Anregung der Kernmagnetisierung im Inneren der Mikrospule mit entgegengesetzter Phase erfolgt.

2. MR-Verfahren nach Anspruch 1, wobei die die Mikrospule (6) drei Abschnitte ($L_1$, $L_2$, $L_3$) mit unterschiedlicher Orientierung aufweist, von denen der mittlere ($L_2$) einen umgekehrten Wicklungssinn aufweist wie die beiden äußeren Abschnitte ($L_1$, $L_3$).

3. MR-Verfahren nach Anspruch 1, wobei die Mikrospule (6) an einem in das Untersuchungsobjekt (10) eingeführten medizinischen Instrument (60) befestigt ist.

4. MR-Verfahren nach Anspruch 1, wobei durch die Mikrospule die Kernmagnetisierung in einem fließenden Medium angeregt wird und zur Fluß-Visualisierung MR-Bilder in unterschiedlichem zeitlichem Abstand zu einem vorangehenden Hochfrequenzimpuls erzeugt werden.

5. MR-Verfahren nach Anspruch 4, wobei MR-Bilder erzeugt werden, die jeweils eine Projektion der Kernmagnetisierung senkrecht zur Flußrichtung darstellen.

6. MR-Anordnung eingerichtet zur Durchführung des Verfahrens nach Anspruch 1 mit einem Magneten zur Erzeugung eines homogenen, stationären Hauptmagnetfeldes im Untersuchungsbereich, einer Hochfrequenz-Spulenanordnung (11,12 ) zum Erzeugen von magnetischen Hochfrequenzimpulsen und zum Empfangen von MR-Signalen aus einem im Untersuchungsbereich befindlichen Untersuchungsobjekt, einem Resonanzkreis mit einer Mikrospule (6) und einer Bildrekonstruktionseinheit zur Rekonstruktion von MR-Bildern,wobei das durch den von Anschlußleitungen freien Resonanzkreis mit einer Mikrospule (6), die mehrere räumlich getrennte Abschnitte ($L_1$, $L_2$, $L_3$) mit unterschiedlichem Wicklungssinn aufweist, lokal bewirkte Phasenmuster in einem von der Bildrekonstruktionseinheit erzeugten MR-Phasenbild sichtbar wird, in dem durch aufeinanderfolgende Abschnitte mit unterschiedlichem Wicklungssinn stets eine Anregung der Kernmagnetisierung im Inneren der Mikrospule mit entgegengesetzter Phase erfolgt.

**Claims**

1. An MR method in which the nuclear magnetization in an object to be examined and present in an examination zone is excited by at least one magnetic RF pulse, in which the MR signals subsequently received by an MR coil are used to form at least one MR image, and in which at least one tuned circuit tuned to the MR frequency, free from connection leads, and comprising a microcoil is introduced into the object to be examined, which microcoil comprises a plurality of spatially separated sections ($L_1$, $L_2$, $L_3$) with different winding directions, such that a phase pattern is locally generated in the MR image in that an excitation of the nuclear magnetization takes place with an opposed phase each time in the interior of the microcoil by means of consecutive sections of different winding directions.

2. An MR method as claimed in Claim 1, wherein the microcoil (6) comprises three spatially separated segments ($L_1$, $L_2$, $L_3$) of different orientation, of which the central one ($L_2$) has a winding direction opposed to that of the two outer ones ($L_1$, $L_3$).

3. An MR method as claimed in Claim 1, wherein the microcoil (6) is attached to a medical instrument (60) introduced into the object (10) to be examined.

4. An MR method as claimed in Claim 1, wherein the nuclear magnetization is excited in a flowing medium by the microcoil, and MR images are generated at different temporal distances from a preceding RF pulse for the purpose of flux visualization.

5. An MR method as claimed in Claim 4, wherein MR images are generated which each represent a respective projection of the nuclear magnetization perpendicular to the flow direction.

6. An MR device designed for carrying out the method as claimed in Claim 1, including a magnet for generating a uniform, steady main magnetic field in the examination zone, an RF coil system (11, 12) for generating magnetic RF pulses and for receiving MR signals from an object to be examined which is present in the examination zone, a tuned circuit with a microcoil (6), and an image reconstruction unit for the reconstruction of MR images, wherein the phase pattern locally processed by the image reconstruction unit, which is free from connection leads and which comprises a microcoil (6) having a plurality of spatially separated segments ($L_1$, $L_2$, $L_3$) with different winding directions, becomes visible in the MR image in that an excitation of the nuclear magnetization takes place with an opposed phase each time in the interior of the microcoil by means of consecutive sections of different winding directions.

**Revendications**

1. Procédé RM dans lequel la magnétisation nucléaire est excitée dans au moins un objet d'examen se trouvant dans une zone d'examen par au moins une impulsion magnétique à haute fréquence, dans lequel les signaux RM reçus ensuite par une bobine RM sont utilisés pour au moins une image RM et dans lequel au moins un circuit de résonance syntonisé à la fréquence RM et exempt de lignes de raccordement d'un circuit de résonance libre avec une micro-bobine est introduit dans l'objet d'examen qui présente plusieurs segments ($L_1$, $L_2$, $L_3$) séparés spatialement avec un sens d'enroulement différent, en procédant toujours à une excitation de la magnétisation nucléaire à l'intérieur de la micro-bobine avec une phase opposée par des segments successifs avec un sens d'enroulement différent.

2. Procédé RM selon la revendication 1, dans lequel la micro-bobine (6) présente trois segments ($L_1$, $L_2$, $L_3$) avec une orientation différente dont le segment central ($L_2$) présente un sens d'enroulement inversé par rapport aux deux segments externes ($L_1$, $L_3$).

3. Procédé RM selon la revendication 1, dans lequel la micro-bobine est fixée à un instrument médical (60) introduit dans l'objet d'examen (10).

4. Procédé RM selon la revendication 1, dans lequel la magnétisation nucléaire est excitée par la micro-bobine dans un milieu en circulation et, pour la visualisation du flux, des images RM sont produites dans un intervalle temporel différent par rapport à une impulsion à haute fréquence précédente.

5. Procédé RM selon la revendication 4, dans lequel des images qui représentent respectivement une projection de la magnétisation nucléaire perpendiculairement à la direction du flux sont produites.

6. Dispositif RM agencé pour la mise en oeuvre du procédé selon la revendication 1 avec un aimant pour la production d'un champ magnétique principal stationnaire homogène dans la zone d'examen, un montage de bobines à haute fréquence (11, 12) pour la production d'impulsions magnétiques à haute fréquence et pour la réception de signaux RM à partir d'un objet d'examen se trouvant dans la zone d'examen, un circuit de résonance avec une micro-bobine (6) et une unité de reconstruction de l'image pour la reconstruction d'images RM, le modèle de phases provoqué localement par le circuit de résonance exempt de lignes de raccordement avec une micro-bobine (6) qui présente plusieurs segments séparés spatialement ($L_1$, $L_2$, $L_3$) avec un sens d'enroulement différent étant visible dans une image de phase RM produite par l'unité de reconstruction de l'image, en procédant toujours à une excitation de la magnétisation nucléaire à l'intérieur de la micro-bobine avec une phase opposée par des segments successifs avec un sens d'enroulement différent.

Fig.1

Fig.2

Fig.3

Fig.4

Fig.5